# FASCICULE DE BREVET EUROPEEN

(11) **EP 2 599 116 B1**
(45) Date de publication et mention de la délivrance du brevet: **02.11.2016**
(21) Numéro de dépôt: 11732489.7
(22) Date de dépôt: 18.07.2011
(51) Int. Cl.: H01L 21/68, B65B 1/04, B65D 19/38, F25D 11/00, F25D 23/06, B65G 49/07

(54) **DISPOSITIF DE STOCKAGE D'ARTICLES SOUS ATMOSPHERE CONTROLEE**
VORRICHTUNG ZUR AUFBEWAHRUNG VON ARTIKELN IN EINER KONTROLLIERTEN ATMOSPHÄRE
DEVICE FOR STORING ARTICLES IN A CONTROLLED ATMOSPHERE

(30) Priorité: 27.07.2010 FR 1056140
(43) Date de publication de la demande: 05.06.2013
(73) Titulaire: L'Air Liquide Société Anonyme pour l'Etude et l'Exploitation des Procédés Georges Claude, 75007 Paris (FR)
(72) Inventeur: MAHERAULT, Vincent, F-91120 Palaiseau (FR); BRIEND, Robert, F-78340 Clayes Sous Bois (FR); LETURMY, Marc, F-78350 Gressey (FR)
(74) Mandataire: Mellul-Bendelac, Sylvie Lisette
(86) Numéro de dépôt international: PCT/EP2011/062242
(87) Numéro de publication internationale: WO 2012/013528

(56) Documents cités:
- WO-A1-95/22728
- WO-A1-2005/053016
- WO-A1-2008/062537
- FR-A1- 2 747 112
- FR-A1- 2 782 068
- US-A1- 2002 124 906

## Description

La présente invention concerne le domaine des dispositifs de stockage d'articles sous atmosphère contrôlée.

On sait en effet que dans de nombreuses branches de l'industrie (telles que l'électronique, ou encore l'alimentaire ou bien la pharmacie), on est amené à stocker de manière plus ou moins provisoire des objets sous atmosphère contrôlée (par exemple un air sec ou encore une atmosphère d'azote ne contenant pas plus d'une teneur limite donnée en oxygène résiduel ou en vapeur d'eau résiduelle), en attente d'utilisation ou en cours de fabrication. Ainsi, en considérant l'exemple de l'industrie électronique, on trouve couramment des moyens de stockage sous azote ou encore sous air sec, de composants électroniques en cours de fabrication, par exemple le stockage de circuits imprimés avant leur assemblage ou encore le stockage de puces nues avant assemblage sur des cartes électroniques.

On trouve également dans cette industrie des moyens de stockage sous air sec ou sous azote de composants électroniques que l'on peut qualifier d'obsolètes ou de stratégiques, que l'utilisateur n'est pas certain de pouvoir se procurer dans les années qui viennent, et pour lesquels il effectue tout simplement son propre stock à long terme.

Les documents FR-2 782 068, US2002/124906, FR-2 747 112 et WO2008/062537 illustrent l'état de la technique de ce domaine des dispositifs de stockage (ou transport) d'articles sous atmosphère contrôlée.

On comprend que de telles opérations de stockage sont nécessaires afin d'éviter toute interaction entre le composant et l'air ambiant, les principaux risques étant liés à la prise d'humidité de l'air ambiant par les composants, à l'oxydation de parties métalliques des composants ou des pistes de circuit imprimé par exemple, à la prise d'humidité par les boîtiers d'encapsulation en plastique, ou encore à une réaction à certaines particules polluantes de l'air ambiant (composés halogénés etc...).

Et l'on sait que parmi les problèmes techniques posés par de telles enceintes de stockage on trouve le fait que ces dispositifs sont utilisés pour de courtes durées, les composants étant introduits ou retirés de l'organe de stockage au fur et à mesure des besoins du site utilisateur, les modules de stockage sont alors ouverts et refermés extrêmement souvent, parfois plusieurs fois par heure.

Si de nombreux dispositifs de ce type sont actuellement disponibles sur le marché, et que la littérature sur ces dispositifs est très abondante (on pourra notamment examiner les documents FR-2 877 641, EP-1 333 469, FR-2 803 647 ou encore EP-1 102 713), la Demanderesse s'est attachée à proposer grâce à la présente invention un nouveau dispositif permettant les avantages et améliorations suivants :
- simplifier les systèmes existants afin d'en diminuer les coûts ;
- permettre la modularité (mise en oeuvre d'un module de stockage unique ou de plusieurs modules superposables, tout en permettant à l'utilisateur de l'utiliser comme un équipement mobile (transport des articles d'un point A à un point B) ;
- l'amélioration des performances par rapport aux systèmes existants ;
- maintenir dans ces conditions de simplicité et de faible coût un niveau de sécurité irréprochable.

Comme on le verra plus en détail dans ce qui suit, la présente invention propose notamment, en un des ses aspects, une nouvelle structure de modules de stockage réalisant une circulation optimale et contrôlée du gaz à l'intérieur du stockage, évitant notamment les zones mortes de circulation, ceci par la présence de système d' « obturateurs », chaque obturateur étant positionné en regard d'une des étagères, entre une des parois du module et l'étagère considérée, de façon à empêcher le passage du gaz verticalement à l'endroit d'un obturateur, et à n'autoriser le passage du gaz que transversalement le long de l'étagère associée à l'obturateur considéré.

La présente invention concerne alors un dispositif de stockage d'articles sous atmosphère contrôlée, comportant :
- au moins un module de stockage apte à accueillir les articles à stocker; module de stockage muni d'au moins une étagère (préférentiellement au moins deux étagères) pour positionner les articles ;
- des moyens d'amenée de gaz à l'intérieur dudit module; et
- des moyens d'évacuation du gaz hors du module,
- au moins un desdits modules de stockage étant de forme sensiblement parallélépipédique, et possédant deux parois sensiblement verticales et opposées et entre lesquelles s'étendent les étagères, et
- les moyens d'amenée de gaz permettant l'injection du gaz dans la partie basse du module ou dans la partie haute du module, au travers d'une des deux dites parois ;
et caractérisé par la mise en oeuvre des mesures suivantes :
- les moyens d'évacuation du gaz sont situés :
   i) sur la même paroi verticale que les moyens d'amenée de gaz,
   j) ou bien sur l'autre paroi verticale lui faisant face à l'extrémité opposée du module par le fait que si les moyens d'amenée de gaz sont situés en partie basse du module alors les moyens d'évacuation sont situés en partie haute du module, tandis que si les moyens d'amenée de gaz sont situés en partie haute du module alors les moyens d'évacuation sont situés en partie basse du module ;
- le module comprend des obturateurs, chaque obturateur étant positionné, en regard d'une des étagères, entre une des deux parois et l'étagère considérée, de façon à empêcher le passage du gaz verticalement à l'endroit d'un obturateur, et à n'autoriser le passage du gaz que transversalement le long de l'étagère associée à l'obturateur considéré ;
et caractérisé en ce que :
- si le module de stockage ne comprend qu'une étagère, alors le module de stockage ne comprend qu'un seul obturateur, situé en regard de l'étagère, entre la paroi au travers de laquelle s'effectue l'arrivée de gaz et l'étagère,
- si le nombre d'étagères est supérieur à un, et si les moyens d'évacuation du gaz sont situés sur une même paroi que les moyens d'amenée de gaz, et si le nombre d'étagères dans le module est pair, alors la dernière étagère du module vue par la circulation du gaz entre l'amenée du gaz et l'évacuation du gaz hors du module est dépourvue d'obturateur.

Selon des modes avantageux de mise en oeuvre de l'invention, celle-ci pourra adopter l'une ou plusieurs de caractéristiques techniques suivantes :
- l'obturateur associé à une étagère est une pièce mécanique dissociée de l'étagère considérée elle-même, mais rendue solidaire de l'étagère considérée, et s'étendant tout le long de l'étagère considérée ;
- l'obturateur associé à une étagère est une partie de l'étagère considérée elle-même, par construction ;
- le dispositif comporte au moins un module technique, accolé et solidaire dudit module de stockage au niveau d'une de ses parois verticales, en communication de fluides avec ce module de stockage, lesdits moyens d'amenée de gaz permettant l'arrivée du gaz dans le module technique et de là l'injection du gaz dans la partie basse du module ou dans la partie haute du module, au travers de la paroi d'accolement, tandis que lesdits moyens d'évacuation du gaz sont situés sur la même paroi que les moyens d'amenée de gaz, et permettent l'évacuation du gaz du module de stockage vers le module technique et de là vers l'extérieur ;
- le dispositif comporte au moins un module technique, accolé et solidaire dudit module de stockage au niveau d'une de ses parois verticales, en communication de fluides avec ce module de stockage, lesdits moyens d'amenée de gaz permettant l'arrivée du gaz dans le module technique et de là l'injection du gaz dans la partie basse du module ou dans la partie haute du module, au travers de la paroi d'accolement du module technique, et le dispositif comporte également au moins un module de collecte et d'évacuation des gaz, également accolé et solidaire dudit module de stockage au niveau de la même paroi verticale d'accolement du module technique, lesdits moyens d'évacuation du gaz permettant l'évacuation des gaz depuis le module de stockage vers le module de collecte et de là vers l'extérieur ;
- le module de collecte et d'évacuation des gaz est muni d'au moins un clapet anti-retour, interdisant le passage des gaz évacués du module de stockage du module de collecte vers le module technique ;
- le dispositif de stockage comporte plusieurs modules de stockage superposés, pour obtenir le volume de stockage global désiré pour les articles, et à chaque module de stockage est associé un module technique, accolé et solidaire du module de stockage considéré au niveau d'une de ses parois verticales, en communication de fluides avec ce module de stockage, des moyens d'amenée de gaz permettant l'arrivée du gaz dans chaque module technique et de là l'injection du gaz dans la partie basse du module associé ou dans la partie haute du module associé, au travers de leur paroi d'accolement, des moyens d'évacuation du gaz étant situés sur la même paroi que les moyens d'amenée de gaz, et permettant l'évacuation du gaz du module de stockage vers le module technique et de là vers l'extérieur ;
- le dispositif de stockage comporte plusieurs modules de stockage superposés, pour obtenir le volume de stockage global désiré pour les articles, et à chaque module de stockage est associé un module technique, accolé et solidaire du module de stockage considéré au niveau d'une de ses parois verticales, en communication de fluides avec ce module de stockage, des moyens d'amenée de gaz permettant l'arrivée du gaz dans chaque module technique et de là l'injection du gaz dans la partie basse du module associé ou dans la partie haute du module associé, au travers de leur paroi d'accolement, et à chaque module de stockage est associé un module de collecte et d'évacuation des gaz, également accolé et solidaire du module de stockage au niveau de la même paroi verticale d'accolement du module technique, lesdits moyens d'évacuation du gaz permettant l'évacuation des gaz depuis le module de stockage vers le module de collecte qui lui est associé et de là vers l'extérieur ;
- les modules de collecte du dispositif forment une colonne verticale creuse unique sur laquelle sont ramenés l'ensemble des gaz évacués de chaque module de stockage du dispositif.

Selon un mode préféré de mise en oeuvre de l'invention, les moyens de contrôle de l'arrivée et de l'extraction des gaz ne comprennent aucun élément électrique, ils sont tous de type pneumatique (avec notamment l'absence notable de toute électrovanne).

D'autres caractéristiques et avantages de la présente invention apparaîtront plus clairement dans la description suivante, donnée à titre illustratif mais nullement limitatif, faite en relation avec les dessins annexés pour lesquels :
- la figure 1 est une vue schématique partielle de face d'un module de stockage à étagères selon l'art antérieur, créant un passage préférentiel du gaz entre une des parois de l'enceinte et les étagères, le long de cette paroi ;
- la figure 2 est une vue schématique partielle de face d'un dispositif conforme à l'invention mettant en oeuvre un nombre d'étagères impair (ici une seule étagère) ;
- la figure 3 est une vue schématique partielle de face d'un dispositif conforme à l'invention mettant en oeuvre un nombre d'étagères impair (ici 5 étagères) ;
- la figure 4 est une vue schématique partielle de face d'un dispositif non conforme à l'invention (nombre d'étagères pair, création d'une zone morte non balayée par le gaz) ;
- la figure 5 est une vue schématique partielle de face d'un dispositif conforme à l'invention mettant en oeuvre le même nombre d'étagères que la figure 4 ;
- la figure 6 est une vue schématique partielle d'un dispositif conforme à l'invention, figure permettant la visualisation d'un des modes de mise en oeuvre des zones de stockage, technique, et de collecte.

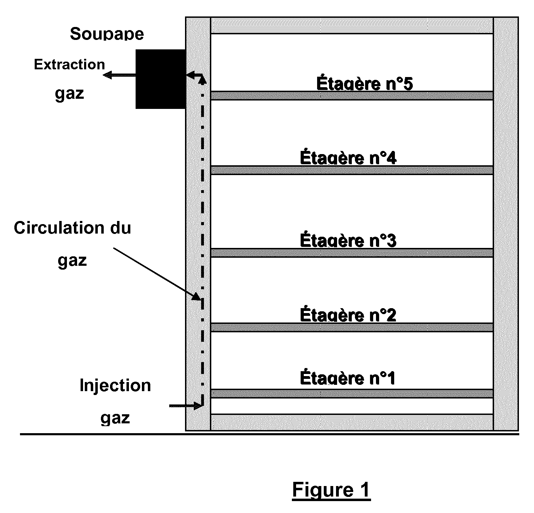

La figure 1 permet de visualiser parfaitement les inconvénients posés par certains dispositifs de l'art antérieur, avec une arrivée d'azote et une évacuation de gaz situés sur la même paroi du module de stockage, le passage préférentiel du gaz se faisant entre la paroi en question et les étagères, même si bien entendu une partie du gaz circule également dans le module et entre les étagères, mais on conçoit alors que des zones du module seront incontestablement très mal couvertes (balayées).

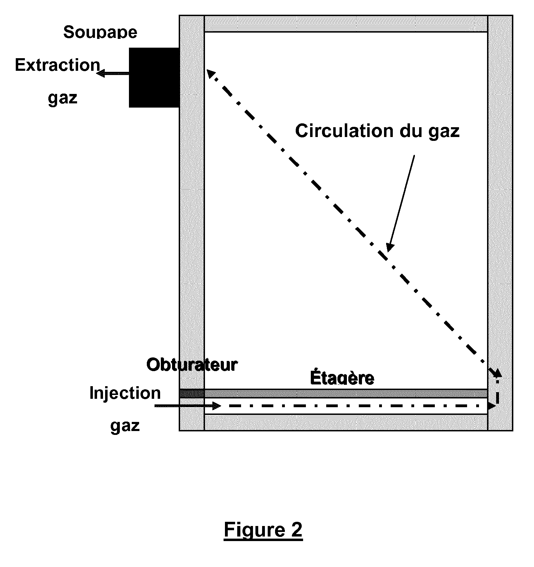

La figure 2 permet quant à elle de bien visualiser l'apport de la présente invention, au travers d'un dispositif (en vue partielle) conforme à l'invention, mettant en oeuvre un module à une seule étagère, l'étagère étant munie (par construction initiale, ou via une pièce rapportée) d'un obturateur en sa partie gauche i.e. entre la paroi d'entrée du gaz et l'étagère.

Sur ce mode de réalisation, les moyens d'évacuation du gaz sont situés sur la même paroi verticale que les moyens d'amenée de gaz, les moyens d'amenée étant situés dans le bas du module tandis que le gaz est évacué en partie haute. Dans un tel cas d'étagère unique, on préférera effectivement selon l'invention positionner l'arrivée de gaz et l'évacuation du gaz sur la même paroi du module comme illustré ici.

Et l'on visualise alors parfaitement comment grâce à cet obturateur unique, on empêche le passage du gaz verticalement à l'endroit de l'obturateur, donc le long de la paroi d'arrivée du gaz, et on n'autorise le passage du gaz que transversalement le long de l'étagère associée à l'obturateur considéré, le gaz atteint alors l'extrémité opposée de l'étagère où il peut passer sur l'autre face de l'étagère, le gaz peut ainsi naviguer sur chaque face de l'étagère afin de ne permettre l'existence d'aucune zone morte qui ne serait pas balayée.

Comme il apparaitra clairement à l'homme du métier, si la vue représentée ici ne permet pas de voir la profondeur du dispositif, on comprend que de façon préférentielle, pour tous les dispositifs conformes à l'invention, les étagères viennent en butée de la paroi arrière du module de stockage (celle du fond) et viennent au maximum vers l'avant du module tout en permettant la fermeture de la porte avant, ceci afin de minimiser les « pertes » de gaz par l'avant ou l'arrière du module, ce qui diminuerait d'autant la circulation selon le chemin privilégié créé par l'invention grâce au jeu d'obturateurs.

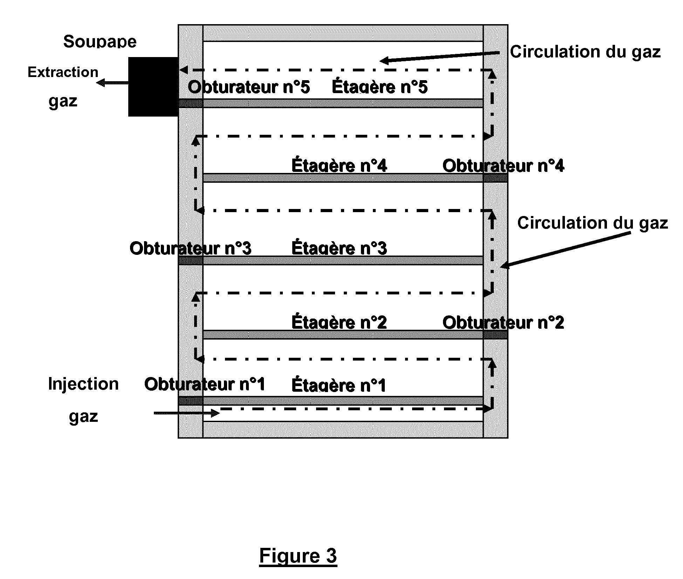

La figure 3 permet quant à elle de bien visualiser l'apport de la présente invention, au travers d'un dispositif (en vue partielle) conforme à l'invention, mettant en oeuvre un module de 5 étagères, chacune des étagères étant muni (par construction initiale, ou via une pièce rapportée) d'un obturateur.

Sur ce mode de réalisation, les moyens d'évacuation du gaz sont situés sur la même paroi verticale que les moyens d'amenée de gaz, les moyens d'amenée étant situés dans le bas du module tandis que le gaz est évacué en partie haute.

Et l'on visualise alors parfaitement comment grâce à ces obturateurs, chaque obturateur empêche le passage du gaz verticalement à l'endroit de l'obturateur, et n'autorise le passage du gaz que transversalement le long de l'étagère associée à l'obturateur considéré, le gaz navigue alors le long des étagères et entre deux étagères afin de ne permettre l'existence d'aucune zone morte qui ne serait pas balayée.

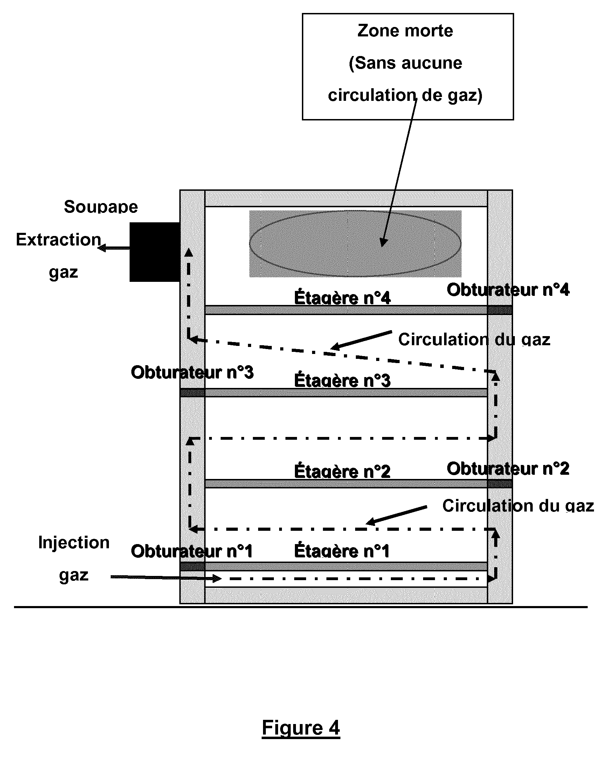

La figure 4 permet quant à elle de visualiser un dispositif non conforme à l'invention : il met en oeuvre un nombre pair d'étagères (quatre), la dernière étagère vue par le gaz étant munie d'un obturateur, en contradiction avec les préconisations de la présente invention, empêchant ainsi le gaz de remonter au dessus de cette dernière étagère, et créant ainsi de fait, au dessus, une zone morte, non balayée par le gaz, ce qui est bien entendu préjudiciable.

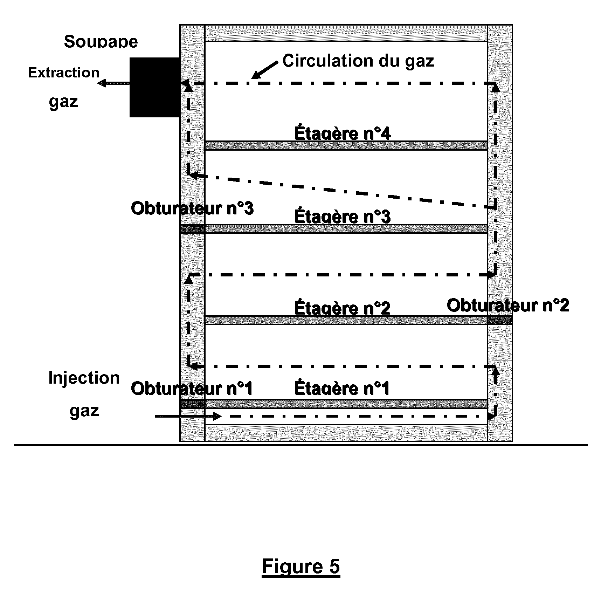

Au contraire de cela, le dispositif de la figure 5, qui est lui conforme à l'invention, avec ce même nombre de quatre étagères (pair), mais ne mettant pas en oeuvre d'obturateur au niveau de la dernière étagère vue par le gaz, permet une circulation des gaz parfaite, depuis l'entrée du gaz dans le dispositif jusqu'à sa sortie, où tous les espaces l'un après l'autre sont balayés par le gaz.

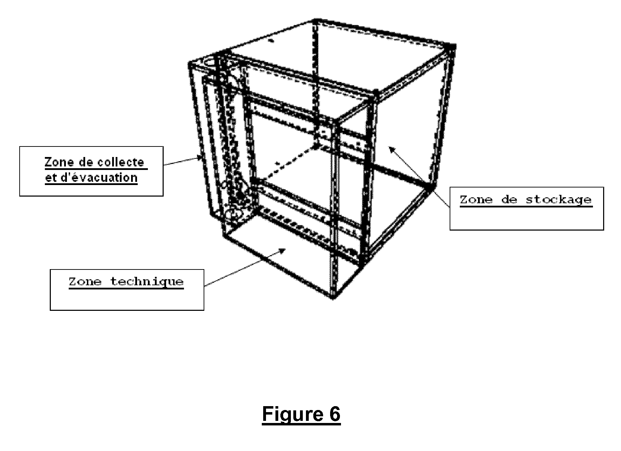

La figure 6 illustre, elle, un des modes de réalisation de l'invention, où le dispositif comprend, outre le module de stockage proprement dit, un module technique, accolé et solidaire du module de stockage au niveau de sa paroi verticale gauche, en communication de fluides avec ce module de stockage et le dispositif comprend un module de collecte et d'évacuation des gaz, également accolé et solidaire du module de stockage au niveau de cette même paroi verticale gauche d'accolement du module technique, les moyens d'évacuation du gaz hors du module de stockage permettant l'évacuation des gaz depuis le module de stockage vers le module de collecte et de là vers l'extérieur (via une canalisation connectée à ce module de collecte, non représentée ici).

On décrit dans ce qui suit un mode de réalisation avantageux de l'invention en tout pneumatique, mettant en oeuvre les deux modules technique et de collecte de la figure 6 :
- afin de réduire les risques d'une surpression trop élevée, pouvant générer un risque pour les personnes et pour le matériel, on met en oeuvre deux déverseurs (régulateur de pression amont) au niveau du module de collecte :
   - Un premier déverseur permet de maintenir une légère surpression dans l'armoire, typiquement de l'ordre de 2 mbar.
   - En cas de défaillance de ce premier déverseur à 2 mbar, le second déverseur taré par exemple à 10 mbar permet de prendre le relais.
   - et dans le cas d'une double défaillance de ces deux déverseurs (bien rare il faut l'avouer) ou encore en cas de disfonctionnement du réseau d'extraction de l'utilisateur on a pris la précaution de mettre en oeuvre un joint d'étanchéité de la porte de la face avant du module de stockage qui se décolle à une pression limite, par exemple supérieure à 15 mbar ;
- on met en oeuvre au niveau de la porte de la face avant du module de stockage une poignée d'ouverture spéciale, dite « à compression », qui permet de supprimer le risque pour l'utilisateur d'être percuté par la porte lors de son ouverture en cas de surpression anormale à l'intérieure de la zone de stockage, poignée dont le fonctionnement peut se résumer ainsi :
   - dans une première phase de rotation de la poignée par l'utilisateur il réalise une première décompression, mais avec maintien de la porte en position rabattue i.e. légèrement entrouverte, joint décollé mais porte retenue par le loquet entrant dans la composition de la poignée ;
   - dans une seconde phase de rotation de la poignée par l'utilisateur il réalise l'ouverture du loquet, permettant cette fois l'ouverture de la porte.

De telles poignées sont par exemple disponibles chez le fournisseur « EMKA ».
- le module technique est étanche : en cas de déconnexion d'un des éléments en aval du détendeur présent dans le module technique pour alimenter le module de stockage, le débit de gaz est limité par un orifice calibré, également présent dans le module technique en aval du détendeur, et tout le reste du débit de gaz est dirigé vers le module de collecte et de là vers la gaine d'extraction à travers un ou des clapets anti-retour positionnés sur la paroi commune entre les modules technique et de collecte ;
- le dispositif est connecté à une source d'azote, par exemple à un réseau d'azote du site utilisateur (qui stocke ses produits dans le module) dont la pression maximale admissible est par exemple de 15 bar. L'ensemble des composants pneumatiques nécessaires au fonctionnement du dispositif sont raccordés entre eux par l'intermédiaire de tubes dont l'assemblage est par exemple réalisé à l'aide de raccords rapides.

Une vanne manuelle permet l'alimentation de l'ensemble de l'équipement, cette vanne peut être positionnée par exemple en face avant ou en face arrière du module technique. Un filtre (seuil de filtration de 20 µm) peut être présent pour assurer la protection de l'ensemble des composants.
- Le réglage de la pression du détendeur associé à l'orifice calibré situé en aval du détendeur, ou à deux orifices calibrés selon un mode avantageux, permet de régler deux débits d'azote, par exemple un débit de purge voisin de 10 Nm³/h et un débit de balayage voisin de 1 Nm³/h.

Comme déjà signalé plus haut l'orifice calibré situé en aval du détendeur limite le débit d'azote en cas de déconnexion d'un tube en aval.
- Un contacteur de porte permet de commander la délivrance ou non des deux débits d'azote en fonction de la fermeture ou l'ouverture de la porte (débit de purge, débit de balayage plus faible).

Le débit de purge et le débit de balayage, tous deux ajustables par le choix d'orifices calibrés, sont déclenchés par la fermeture de la porte, la durée de ce débit de purge étant fixée par un temporisateur pneumatique (réglable), et quand le débit de purge s'arrête (seul) le débit de balayage subsiste.
- Lors de l'ouverture de la porte tant le débit de purge que le débit de balayage s'arrêtent.

Les avantages de l'invention apparaissent alors clairement à l'homme du métier :
- la structure proposée ici est très simple, ce qui diminue nettement les coûts de fabrication, sans oublier le fait que selon un mode préféré de mise en oeuvre de l'invention les moyens de contrôle électriques de la mise en oeuvre du gaz sont évités, au profit du pneumatique (fluidique), entraînant la diminution du nombre de composants mise en oeuvre mais aussi un coût d'achat de ces composants nettement moindre (à titre d'exemple le coût d'une électrovanne est très élevé comme il est bien connu de l'homme du métier. On notera aussi que le mode préféré « pneumatique » élimine également les risques électriques ;
- la structure proposée ici permet la modularité et la superposition des modules de stockage comme on l'a bien montré, et une évacuation simplifiée grâce à une des structures proposée de l'invention comportant des modules de collecte qui forment une colonne verticale creuse unique sur laquelle sont ramenés l'ensemble des gaz évacués de chaque module de stockage du dispositif ;
- l'un des modes de l'invention étant purement pneumatique, le dispositif de l'invention est très facilement transportable puisqu'il est tout simplement possible de raccorder une bouteille d'azote au dispositif lors de son transport, aucune autre source d'énergie n'étant nécessaire (énergie purement fluidique) ;
- les performances d'inertage ou de maintien d'une atmosphère contrôlée (par exemple en point de rosée) vont de soi : grâce à la structure revendiquée chaque zone est balayée, on évite les volumes morts, la purge du module de stockage est automatiquement bien plus efficace.

## Revendications

1. Dispositif de stockage d'articles sous atmosphère contrôlée, comportant :
- au moins un module de stockage apte à accueillir les articles à stocker; module de stockage muni d'au moins une étagère pour positionner les articles ;
- des moyens d'amenée de gaz à l'intérieur dudit au moins un module; et
- des moyens d'évacuation du gaz hors dudit au moins un module,
- ledit au moins un module de stockage étant de forme sensiblement parallélépipédique et possédant deux parois sensiblement verticales et opposées et entre lesquelles s'étendent la ou les étagères, et
- lesdits moyens d'amenée de gaz permettant l'injection du gaz dans la partie basse dudit module ou dans la partie haute dudit module, au travers d'une des deux dites parois du module ;
et ledit au moins un module étant **caractérisé par** la mise en oeuvre des mesures suivantes :
- les moyens d'évacuation du gaz sont situés :
i) sur la même paroi verticale que les moyens d'amenée de gaz,
j) ou bien sur l'autre paroi verticale lui faisant face à l'extrémité opposée du module par le fait que si les moyens d'amenée de gaz sont situés en partie basse du module alors les moyens d'évacuation sont situés en partie haute du module, tandis que si les moyens d'amenée de gaz sont situés en partie haute du module alors les moyens d'évacuation sont situés en partie basse du module ;
- le module de stockage comprend un ou des obturateurs, chaque obturateur étant positionné, en regard d'une des étagères, entre une des deux parois et l'étagère considérée, de façon à empêcher le passage du gaz verticalement à l'endroit d'un obturateur, et à n'autoriser le passage du gaz que transversalement le long de l'étagère associée à l'obturateur considéré ;
et ledit au moins un module étant **caractérisé en ce que** :
- si le module de stockage ne comprend qu'une étagère, alors le module de stockage ne comprend qu'un seul obturateur, situé en regard de l'étagère, entre la paroi au travers de laquelle s'effectue l'arrivée de gaz et l'étagère,
- si le nombre d'étagères dans le module est pair, et si les moyens d'évacuation du gaz sont situés sur une même paroi que les moyens d'amenée de gaz, alors la dernière étagère du module vue par la circulation du gaz entre l'amenée du gaz et l'évacuation du gaz hors du module est dépourvue d'obturateur.

2. Dispositif de stockage d'articles sous atmosphère contrôlée selon la revendication 1, **se caractérisant en ce que** l'obturateur associé à une étagère est une pièce mécanique dissociée de l'étagère considérée elle-même, mais rendue solidaire de l'étagère considérée, et s'étendant tout le long de l'étagère considérée.

3. Dispositif de stockage d'articles sous atmosphère contrôlée selon la revendication 1, **se caractérisant en ce que** l'obturateur associé à une étagère est une partie de l'étagère considérée elle-même, par construction.

4. Dispositif de stockage d'articles sous atmosphère contrôlée selon l'une des revendications 1 à 3, **se caractérisant par** la mise en oeuvre des mesures suivantes :
- il comporte au moins un module technique, accolé et solidaire dudit au moins un module de stockage au niveau d'une de ses parois verticales, en communication de fluides avec ce module de stockage ;
- lesdits moyens d'amenée de gaz permettent l'arrivée du gaz dans le module technique et de là l'injection du gaz dans la partie basse du module ou dans la partie haute du module, au travers de la paroi d'accolement du module technique ;
- lesdits moyens d'évacuation du gaz sont situés sur la même paroi que les moyens d'amenée de gaz, et permettent l'évacuation du gaz du module de stockage vers le module technique et de là vers l'extérieur.

5. Dispositif de stockage d'articles sous atmosphère contrôlée selon l'une des revendications 1 à 3, **se caractérisant par** la mise en oeuvre des mesures suivantes :
- il comporte au moins un module technique, accolé et solidaire dudit au moins un module de stockage au niveau d'une de ses parois verticales, en communication de fluides avec ce module de stockage ;
- lesdits moyens d'amenée de gaz permettent l'arrivée du gaz dans le module technique et de là l'injection du gaz dans la partie basse du module ou dans la partie haute du module, au travers de la paroi d'accolement du module technique;
- il comporte au moins un module de collecte et d'évacuation des gaz, également accolé et solidaire du module de stockage au niveau de la même paroi verticale d'accolement du module technique, lesdits moyens d'évacuation du gaz permettant l'évacuation des gaz depuis le module de stockage vers le module de collecte et de là vers l'extérieur.

6. Dispositif de stockage d'articles sous atmosphère contrôlée selon la revendication 5, **se caractérisant en ce que** le module de collecte et d'évacuation des gaz est muni d'au moins un clapet anti-retour, interdisant le passage des gaz évacués du module de stockage depuis le module de collecte vers le module technique.

7. Dispositif de stockage d'articles sous atmosphère contrôlée selon la revendication 4, **se caractérisant en ce qu'**il comporte plusieurs modules de stockage superposés, conformes audit au moins un module de stockage, pour obtenir le volume de stockage global désiré pour les articles, et **en ce qu'**à chaque module de stockage est associé un module technique, accolé et solidaire du module de stockage considéré au niveau d'une de ses parois verticales, en communication de fluides avec ce module de stockage, des moyens d'amenée de gaz permettant l'arrivée du gaz dans chaque module technique et de là l'injection du gaz dans la partie basse du module associé ou dans la partie haute du module associé, au travers de leur paroi d'accolement, des moyens d'évacuation du gaz étant situés sur la même paroi que les moyens d'amenée de gaz, et permettant l'évacuation du gaz du module de stockage vers le module technique associé et de là vers l'extérieur.

8. Dispositif de stockage d'articles sous atmosphère contrôlée selon la revendication 5, **se caractérisant en ce qu'**il comporte plusieurs modules de stockage superposés, conformes audit au moins un module de stockage, pour obtenir le volume de stockage global désiré pour les articles, et **en ce qu'**à chaque module de stockage est associé un module technique, accolé et solidaire du module de stockage considéré au niveau d'une de ses parois verticales, en communication de fluides avec ce module de stockage, des moyens d'amenée de gaz permettant l'arrivée du gaz dans chaque module technique et de là l'injection du gaz dans la partie basse du module associé ou dans la partie haute du module associé, au travers de leur paroi d'accolement, et **en ce qu'**à chaque module de stockage est associé un module de collecte et d'évacuation des gaz, également accolé et solidaire du module de stockage au niveau de la même paroi verticale d'accolement du module technique, lesdits moyens d'évacuation du gaz permettant l'évacuation des gaz depuis le module de stockage vers le module de collecte qui lui est associé et de là vers l'extérieur.

9. Dispositif de stockage d'articles sous atmosphère contrôlée selon la revendication 8, **se caractérisant en ce que** les modules de collecte du dispositif forment une colonne verticale creuse unique sur laquelle sont ramenés l'ensemble des gaz évacués de chaque module de stockage du dispositif.

10. Dispositif de stockage d'articles sous atmosphère contrôlée selon l'une des revendications précédentes, **se caractérisant en ce que** lesdits moyens d'amenée de gaz ne comprennent que des éléments de type pneumatique, à l'exclusion de tout élément électrique.

## Patentansprüche

1. Vorrichtung zum Lagern von Artikeln unter kontrollierter Atmosphäre, Folgendes umfassend:
- zumindest ein Lagermodul, das imstande ist, die zu lagernden Artikel aufzunehmen; Lagermodul mit zumindest einem Regal zum Positionieren der Artikel;
- Mittel zum Zuführen von Gas ins Innere des zumindest einen Moduls; und
- Mittel zum Ausbringen des Gases aus dem zumindest einen Modul,
- wobei das zumindest eine Lagermodul eine im Wesentlichen quaderförmige Form aufweist und zwei im Wesentlichen vertikale und gegenüberliegende Wände besitzt, und zwischen denen sich das oder die Regale erstrecken, und
- die Mittel zum Zuführen von Gas das Injizieren des Gases in den unteren Abschnitt des Moduls oder in den oberen Abschnitt des Moduls durch eine der beiden Wände des Moduls hindurch ermöglichen;
und das zumindest eine Modul durch das Ergreifen der folgenden Maßnahmen gekennzeichnet ist:
- die Mittel zum Ausbringen des Gases befinden sich:
i) an derselben vertikalen Wand, wie die Mittel zum Zuführen von Gas,
j) oder aber an der anderen vertikalen Wand, die ihr am entgegengesetzten Ende des Moduls gegenüberliegt, durch die Tatsache, dass, wenn sich die Mittel zum Zuführen von Gas im unteren Abschnitt des Moduls befinden, sich die Mittel zum Ausbringen im oberen Abschnitt des Moduls befinden, während, wenn sich die Mittel zum Zuführen von Gas im oberen Abschnitt des Moduls befinden, sich die Mittel zum Ausbringen im unteren Abschnitt des Moduls befinden;
- das Lagermodul einen oder mehrere Verschlüsse umfasst, wobei jeder Verschluss gegenüber einem der Regale zwischen einer der beiden Wände und dem betrachteten Regal positioniert ist, um den Durchlass des Gases vertikal an der Stelle eines Verschlusses zu verhindern, und den Durchlass des Gases nur in Querrichtung entlang des Regals freizugeben, das dem betrachteten Verschluss zugeordnet ist;
und das zumindest eine Modul **dadurch gekennzeichnet ist, dass**:
- falls das Lagermodul nur ein Regal umfasst, das Lagermodul nur einen einzigen Verschluss umfasst, der sich gegenüber dem Regal zwischen der Wand, durch die hindurch die Zuführung des Gases erfolgt, und dem Regal befindet,
- falls die Anzahl der Regale im Modul eine gerade Zahl ist, und falls sich die Mittel zum Ausbringen des Gases an einer selben Wand befinden, wie die Mittel zum Zuführen von Gas, so ist das letzte Regal des Moduls, in Richtung der Gasströmung zwischen der Zuführung des Gases und dem Ausbringen des Gases aus dem Modul gesehen, mit keinem Verschluss versehen.

2. Vorrichtung zum Lagern von Artikeln unter kontrollierter Atmosphäre nach Anspruch 1, **dadurch gekennzeichnet, dass** der Verschluss, der einem Regal zugeordnet ist, ein mechanisches Teil ist, das vom betrachteten Regal selbst getrennt ist, jedoch fest mit dem betrachteten Regal verbunden wird, und sich entlang des gesamten betrachteten Regals erstreckt.

3. Vorrichtung zum Lagern von Artikeln unter kontrollierter Atmosphäre nach Anspruch 1, **dadurch gekennzeichnet, dass** der Verschluss, der einem Regal zugeordnet ist, konstruktiv ein Teil des betrachteten Regals selbst ist.

4. Vorrichtung zum Lagern von Artikeln unter kontrollierter Atmosphäre nach einem der Ansprüche 1 bis 3, durch das Ergreifen der folgenden Maßnahmen gekennzeichnet, dass:
- sie zumindest ein technisches Modul umfasst, das im Bereich einer seiner vertikalen Wände, in Fluidverbindung mit dem Lagermodul, an das zumindest eine Lagermodul angebunden und fest damit verbunden ist;
- die Mittel zum Zuführen von Gas den Eintritt des Gases in das technische Modul, und von dort die Injektion des Gases in den unteren Abschnitt des Moduls oder in den oberen Abschnitt des Moduls durch die Anbindungswand des technischen Moduls hindurch ermöglichen;
- sich die Mittel zum Ausbringen des Gases an derselben Wand wie die Mittel zum Zuführen von Gas befinden, und das Ausbringen des Gases aus dem Lagermodul zum technischen Modul und von dort aus ins Freie ermöglichen.

5. Vorrichtung zum Lagern von Artikeln unter kontrollierter Atmosphäre nach einem der Ansprüche 1 bis 3, durch das Ergreifen der folgenden Maßnahmen gekennzeichnet, dass:
- sie zumindest ein technisches Modul umfasst, das im Bereich einer seiner vertikalen Wände, in Fluidverbindung mit diesem Lagermodul, an das zumindest eine Lagermodul angebunden und fest damit verbunden ist;
- die Mittel zum Zuführen von Gas den Eintritt des Gases in das technische Modul, und von dort die Injektion des Gases in den unteren Abschnitt des Moduls oder in den oberen Abschnitt des Moduls durch die Anbindungswand des technischen Moduls hindurch ermöglichen;
- sie zumindest ein Modul zum Sammeln und Ausbringen der Gase umfasst, das ebenfalls im Bereich derselben vertikalen Anbindungswand des technischen Moduls an das Lagermodul angebunden und fest damit verbunden ist, wobei die Mittel zum Ausbringen des Gases das Ausbringen des Gases aus dem Lagermodul in das Modul zum Sammeln und von dort aus ins Freie ermöglichen.

6. Vorrichtung zum Lagern von Artikeln unter kontrollierter Atmosphäre nach Anspruch 5, **dadurch gekennzeichnet, dass** das Modul zum Sammeln und Ausbringen der Gase mit zumindest einem Rückschlagventil versehen ist, das den Durchlass der Gase, die aus dem Lagermodul vom Modul zum Sammeln zum technischen Modul ausgebracht werden, untersagt.

7. Vorrichtung zum Lagern von Artikeln unter kontrollierter Atmosphäre nach Anspruch 4, **dadurch gekennzeichnet, dass** sie mehrere überlagerte Lagermodule umfasst, die dem zumindest einen Lagermodul entsprechen, um das gewünschte globale Lagervolumen für die Artikel zu erhalten, und dadurch, dass jedem Lagermodul ein technisches Modul zugeordnet ist, das im Bereich einer seiner vertikalen Wände, in Fluidverbindung mit diesem Lagermodul, an das betrachtete Lagermodul angebunden und fest damit verbunden ist, wobei Mittel zum Zuführen von Gas den Eintritt des Gases in jedes technische Modul, und von dort das Injizieren des Gases in den unteren Abschnitt des zugeordneten Moduls oder in den oberen Abschnitt des zugeordneten Moduls durch ihre Anbindungswand hindurch ermöglicht, wobei sich Mittel zum Ausbringen des Gases an derselben Wand befinden, wie die Mittel zum Zuführen von Gas, und das Ausbringen des Gases aus dem Lagermodul zum zugeordneten technischen Modul, und von dort aus ins Freie ermöglichen.

8. Vorrichtung zum Lagern von Artikeln unter kontrollierter Atmosphäre nach Anspruch 5, **dadurch gekennzeichnet, dass** sie mehrere überlagerte Lagermodule umfasst, die dem zumindest einen Lagermodul entsprechen, um das gewünschte globale Lagervolumen für die Artikel zu erhalten, und dadurch, dass jedem Lagermodul ein technisches Modul zugeordnet ist, das im Bereich einer seiner vertikalen Wände, in Fluidverbindung mit diesem Lagermodul an das betrachtete Lagermodul angebunden und fest damit verbunden ist, wobei Mittel zum Zuführen von Gas den Eintritt des Gases in jedes technische Modul, und von dort das Injizieren des Gases in den unteren Abschnitt des zugeordneten Moduls oder in den oberen Abschnitt des zugeordneten Moduls durch ihre Anbindungswand hindurch ermöglicht, und dadurch, dass jedem Lagermodul ein Modul zum Sammeln und Ausbringen der Gase zugeordnet ist, das auch im Bereich derselben vertikalen Anbindungswand des technischen Moduls an das Lagermodul angebunden und fest damit verbunden ist, wobei die Mittel zum Ausbringen des Gases das Ausbringen der Gase aus dem Lagermodul zum Modul zum Sammeln, das ihm zugeordnet ist, und von dort aus ins Freie ermöglicht.

9. Vorrichtung zum Lagern von Artikeln unter kontrollierter Atmosphäre nach Anspruch 8, **dadurch gekennzeichnet, dass** die Module zum Sammeln der Vorrichtung eine einzige vertikale hohle Säule bilden, auf die sämtliche Gase zugeführt werden, die aus jedem Lagermodul der Vorrichtung ausgebracht werden.

10. Vorrichtung zum Lagern von Artikeln unter kontrollierter Atmosphäre nach einem der vorherigen Ansprüche, **dadurch gekennzeichnet, dass** die Mittel zum Zuführen von Gas nur Elemente pneumatischer Art unter Ausschluss eines jeden elektrischen Elements umfassen.

## Claims

1. Device for storing articles in a controlled atmosphere, including:
- at least one storage module suitable for receiving the articles to be stored; the storage module being equipped with at least one rack for positioning the articles;
- means for supplying gas inside said at least one module; and
- means for discharging the gas outside said at least one module,
- said at least one storage module being of substantially parallelepipedic shape and having two substantially vertical and opposite walls and between which the rack(s) extend, and
- said means for supplying gas enabling the injection of the gas into the lower part of said module or into the upper part of said module, via one of the two said walls of the module;
and said at least one module being **characterised by** the implementation of the following measures:
- the means for discharging the gas are situated:
i) on the same vertical wall as the means for supplying gas,
j) or on the other vertical wall facing thereto at the opposite end of the module in that if the means for supplying gas are situated in the lower part of the module, then the discharge means are situated in the upper part of the module, whereas if the means for supplying gas are situated in the upper part of the module then the discharge means are situated in the lower part of the module;
- the storage module comprises one or more closure members, each closure member being positioned, facing one of the racks, between one of the two walls and the rack in question, so as to prevent the passage of the gas vertically in respect of a closure member, and only allowing the passage of the gas transversally along the rack associated with the closure member in question;
and said at least one module being **characterised in that**:
- if the storage module only comprises one rack, then the storage module only comprises a single closure member, situated facing the rack, between the wall through which the gas supply arrives and the rack,
- if the number of racks in the module is even, and if the means for discharging the gas are situated on the same wall as the means for supplying the gas, then the final rack of the module encountered by the flow of gas between the gas supply and the gas discharge outside the module is devoid of a closure member.

2. Device for storing articles in a controlled atmosphere according to claim 1, **characterised in that** the closure member associated with a rack is a mechanical part separate from the rack in question, but rendered rigidly connected to the rack in question, and extending along the rack in question.

3. Device for storing articles in a controlled atmosphere according to claim 1, **characterised in that** the closure member associated with a rack is a part of the rack in question, by design.

4. Device for storing articles in a controlled atmosphere according to any one of claims 1 to 3, **characterised by** the implementation of the following measures:
- it includes at least one technical module, adjoined and rigidly connected to said at least one storage module at one of the vertical walls thereof, fluidically connected with this storage module;
- said means for supplying gas enabling the supply of the gas into the technical module and as such the injection of the gas into the lower part of the module or into the upper part of the module, through the adjoining wall of the technical module;
- said means for discharging the gas are situated on the same wall as the means for supplying gas, and enable the discharge of the gas from the storage module to the technical module and as such to the outside.

5. Device for storing articles in a controlled atmosphere according to any one of claims 1 to 3, **characterised by** the implementation of the following measures:
- it includes at least one technical module, adjoined and rigidly connected to said at least one storage module at one of the vertical walls thereof, fluidically connected with this storage module;
- said means for supplying gas enabling the supply of the gas into the technical module and as such the injection of the gas into the lower part of the module or into the upper part of the module, through the adjoining wall of the technical module;
- it includes at least one module for collecting and discharging gases, also adjoined and rigidly connected to the storage module at the adjoining vertical wall of the technical module, said means for discharging the gas enabling the discharge of the gas from the storage module to the collection module and as such to the outside.

6. Device for storing articles in a controlled atmosphere according to claim 5, **characterised in that** the module for collecting and discharging gases is equipped with at least one non-return selector valve, blocking the passage of the gases discharged from the storage module from the collection module to the technical module.

7. Device for storing articles in a controlled atmosphere according to claim 4, **characterised in that** it includes a plurality of stacked storage modules, corresponding to said at least one storage module, to obtain the overall storage volume sought for the articles, and **in that** each storage module has an associated technical module, adjoined and rigidly connected to the storage module in question at one of the vertical walls thereof, fluidically connected with this storage module, means for supplying gas enabling the supply of the gas into each technical module and as such the injection of the gas into the lower part of the associated module or into the upper part of the associated module, through the adjoining wall thereof, means for discharging the gas being situated on the same wall as the means for supplying gas, and enabling the discharge of the gas from the storage module to the associated technical module and as such to the outside.

8. Device for storing articles in a controlled atmosphere according to claim 5, **characterised in that** it includes a plurality of stacked storage modules, corresponding to said at least one storage module, to obtain the overall storage volume sought for the articles, and **in that** each storage module has an associated technical module, adjoined and rigidly connected to the storage module in question at one of the vertical walls thereof, fluidically connected with this storage module, means for supplying gas enabling the supply of the gas into each technical module and as such the injection of the gas into the lower part of the associated module or into the upper part of the associated module, through the adjoining wall thereof, and **in that** each storage module has an associated module for collecting and discharging gases, also adjoined and rigidly connected to the storage module at the same adjoining vertical wall of the technical module, said means for discharging the gas enabling the discharge of the gas from the storage module to the collection module and as such to the outside.

9. Device for storing articles in a controlled atmosphere according to claim 8, **characterised in that** the collection modules of the device form a single hollow vertical column whereto all the gases discharged from each storage module of the device are conveyed.

10. Device for storing articles in a controlled atmosphere according to any one of the preceding claims, **characterised in that** said means for supplying gas merely comprise pneumatic type elements, excluding any electrical element.
